## Europäisches Patentamt
## European Patent Office
## Office européen des brevets

(19)

(11) Veröffentlichungsnummer: **0 048 995**
**B1**

(12)

# EUROPÄISCHE PATENTSCHRIFT

(45) Veröffentlichungstag der Patentschrift:
**09.11.83**

(51) Int. Cl.³: **B 28 D 7/04,** H 01 L 21/68,
**B 65 G 47/91**

(21) Anmeldenummer: **81107773.4**

(22) Anmeldetag: **30.09.81**

(54) Verfahren zum Aufnehmen von Kristallscheiben.

(30) Priorität: **30.09.80 DE 3036829**

(43) Veröffentlichungstag der Anmeldung:
**07.04.82 Patentblatt 82/14**

(45) Bekanntmachung des Hinweises auf die Patenterteilung:
**09.11.83 Patentblatt 83/45**

(84) Benannte Vertragsstaaten:
**BE CH DE FR GB IT LI NL**

(56) Entgegenhaltungen:
**DE - A - 2 609 754**
**DE - A - 2 732 728**
**DE - B - 1 928 203**
**US - A - 3 438 668**

(73) Patentinhaber: **Wacker-Chemitronic Gesellschaft für Elektronik-Grundstoffe mbH,**
**Johannes-Hess-Strasse 24, D-8263 Burghausen (DE)**

(72) Erfinder: **Schiele, Bernd, Dr. Dipl.-Ing.,**
**Riemerschmid-Strasse 9, D-8263 Burghausen (DE)**
Erfinder: **Niedermeier, Johann, Hochkalter Strasse 4,**
**D-8261 Burgkirchen (DE)**

EP 0 048 995 B1

## Verfahren zum Aufnehmen von Kristallscheiben

Die Erfindung betrifft ein Verfahren zum Aufnehmen von Kristallscheiben, die durch einen Trennvorgang gewonnen werden, unter Ausnutzung der Sogwirkung an der Scheibe vorbeiströmenden Gases.

Kristallscheiben werden zumeist durch Zersägen von Kristallstäben gewonnen. Problematisch ist nicht zuletzt die Endphase des Trennvorgangs, in der nur noch eine dünne, mechanisch immer labiler werdende Restverbindung zwischen Scheibe und Stab besteht: aufgrund der beim Trennen auftretenden Kräfte wird diese Restverbindung schließlich abgedreht oder abgebrochen, wodurch auf der Scheibenoberfläche ein Stumpf verbleibt, der in einem weiteren Arbeitsgang abgetragen werden muß. Oftmals kommt es auch zu Ausbrüchen in der Scheibenoberfläche, die eine weitere Verwendung der Scheibe nicht mehr zulassen.

Zur Vermeidung dieser Nachteile sollte die abzutrennende Scheibe möglichst festgehalten werden. Erfahrungsgemäß kann dieses Problem jedoch nicht dadurch gelöst werden, daß die zu gewinnende Scheibe durch Greifer und dergleichen gefaßt wird, da an den Berührungsstellen der Greifwerkzeuge Kratzer oder gar Randausbrüche an der Scheibe auftreten. Weiterhin werden die zumeist sehr dünnen Kristallscheiben bei allzu festem Zugriff durchgebogen, mit der Folge, daß kein exakt planparalleler Schnitt mehr zustande kommt.

Es wurde deshalb bereits ein Haltewerkzeug entwickelt, das nach dem aerodynamischen Prinzip arbeitet: dieses Werkzeug weist eine kreisrunde Haltefläche auf mit einer im Zentrum der Fläche versenkt eingearbeiteten Düse, aus der in spitzem Winkel zur Haltefläche Gas ausströmt. Ab einem gewissen Abstand des Haltewerkzeugs zur Scheibe wird die Scheibe durch das vorbeiströmende Gas nach dem Bernoullischen Prinzip angesaugt. Um ein Wegrutschen der Flattern der Scheibe zu verhindern, weist dieses bekannte Haltewerkzeug einen zwei Drittel der Haltefläche umfassenden, erhöhten Anschlag auf. Der Gasstrom bläst die Scheibe an den Anschlag, wodurch Kratzer oder Ausbrüche an der Scheibe verursacht werden können. Derartige Beschädigungen können ebenso beim Loslassen der Scheibe auftreten, wenn sie seitlich abrutscht oder am Anschlag schleift.

Es wurde deshalb gemäß DE-A-2 609 754 auch bereits ein Haltewerkzeug vorgeschlagen, das ein berührungsloses Aufnehmen der Scheibe gestattet. Dieses Werkzeug arbeitet ebenso nach dem bereits oben skizzierten aerodynamischen Prinzip. Die Scheibe schwebt auf dem durch das ausströmende Gas aufgebauten Gaspolster und wird gleichzeitig durch die Saugwirkung des am Rande der Scheibe in vorzugsweise laminarer Strömung vorbeistreichenden Gases festgehalten. Beschädigungen der Scheibe durch das Haltewerkzeug werden dadurch naturgemäß vermieden.

Aufgabe der Erfindung war es nun, ein Verfahren zu entwickeln, das die Vorteile des berührungsfreien Aufnehmens der Scheibe mit den Vorteilen einer möglichst festen Verbindung zwischen Scheibe und Haltewerkzeug vereint.

Es wurde nun überraschenderweise festgestellt, daß eine lediglich annähernd punktförmige Abstützung der Scheibe im Zentrum ausreicht, die obengenannte Zielsetzung zu erreichen. Hierbei wird die Scheibe unter Ausnutzung des bereits beschriebenen aerodynamischen Prinzips auf die annähernd punktförmige Abstützung gedrückt.

Gegenstand der Erfindung ist ein Verfahren zum Aufnehmen von Kristallscheiben gemäß dem Oberbegriff des Anspruchs 1, das dadurch gekennzeichnet ist, daß die Scheibe im Zentrum annähernd punktförmig abgestützt wird.

Weiterhin ist Gegenstand der Erfindung ein Haltewerkzeug zur Durchführung des Verfahrens, das dadurch gekennzeichnet ist, daß die Haltefläche des Werkzeugs im Zentrum eine punktförmig auslaufende Erhöhung aufweist.

Die Abstützung erfolgt an einer zentral angebrachten Erhöhung der Haltefläche des Haltewerkzeuges. Diese Erhöhung weist eine derart zur Scheibe zeigende Krümmung auf, daß nur eine annähernd punktförmige Abstützung zustande kommt. Diese Erhöhung kann die Form einer Kuppe, einer Nadel, eines Stifts, einer Kugel, vorzugsweise die einer Kugel, aufweisen. Der Durchmesser der Kugel beträgt etwa 0,5 bis 3% des Durchmessers der Haltefläche. Die Abstützung weist vorteilhafterweise eine polierte Oberfläche auf und ist aus Material gefertigt, das eine größere Werkstoffhärte aufweist, als die zu gewinnende Scheibe.

Die Durchführung des Verfahrens erfolgt in der Weise, daß der abzutrennenden Scheibe während, zumindest jedoch in der Schlußphase des Trennvorgangs, ein Haltewerkzeug mit parallel zur Scheibe angeordneter Haltefläche so weit angenähert und derart justiert wird, daß die als Abstützung dienende Erhöhung in der Haltefläche das Zentrum der Scheibe trifft. Dabei wird die Scheibe von einem aus der Haltefläche austretenden, unter spitzem Winkel auf die Scheibe auftretenden Gasstrom umspült. Der Gasstrom erzeugt dabei in an sich bekannter Weise eine Sogwirkung, der das Zentrum der Scheibe auf die Abstützung preßt, während die Scheibe über ihre ganze Ausdehnung auf dem durch den Gasstrom erzeugten Gaspolster schwebt und dabei in ihrer Lage stabilisiert wird. Die auf die Scheibe wirkende Saugkraft wird in erster Linie durch Variieren des Gasvolumendurchflusses und durch die lichte Weite der Gasdüse gesteuert. Die Düse ist zumeist in der Form eines Ringspalts im Haltewerkzeug ausgebildet. Zweckmäßigerweise sollte die Strömung innerhalb der Düse laminar sein, da auftretende Turbulenzen höhere energetische Verluste zur Folge haben.

Nach dem Abtrennen der Scheibe vom Stab wird die Scheibe abgeschwenkt und einer Sammelvorrichtung übergeben.

Das Verfahren läßt sich allgemein innerhalb solcher Trennverfahren zur Gewinnung von Kristallscheiben anwenden, bei denen Scheiben einzeln gewonnen werden. Bevorzugt wird das erfindungsgemäße Verfahren angewandt beim Trennen mittels Innenlochsägen. Hierbei wird ein kreisrundes Sägeblatt an der Peripherie eingespannt, das ein konzentrisch angebrachtes Loch aufweist, dessen zumeist mit Diamanten besetzter Umfang die eigentliche Schnittkante bildet. Der in Scheiben zu zerteilende Kristallstab wird, vorzugsweise um seine Längsachse rotierend, in das Loch im Zentrum des Sägeblatts in einer Tiefe entsprechend der erwünschten Scheibendicke abgesenkt und nach außen gegen die Sägekante bewegt.

Grundsätzlich ist das Verfahren sowohl bei horizontaler als auch bei vertikaler Anordnung durchführbar.

Das Verfahren wird insbesondere beim Trennen harter Materialien eingesetzt. Beispiele für derartige Materialien sind elementares Silicium, Galliumarsenid, Saphir, Gadolinium-Gallium-Granat, Lithiumniobat und andere.

Das Haltewerkzeug besteht aus einem Abnehmerteller, der zumeist an einer Schwenkvorrichtung zum Weitertransport der Scheiben angebracht ist. Der Abnehmerteller ist im Zentrum mit einer Bohrung versehen, die in Richtung Scheibe konisch ausgeführt ist. In diese Bohrung ist ein Kegelstumpf eingepaßt, der in der, der zu gewinnenden Scheibe abgewandten Seite mit einer über eine Druckregelung zu steuernden Gasquelle verbunden ist.

Die Form des Abnehmertellers ist vorzugsweise kreisrund, er kann im speziellen Fall jedoch jede andere Geometrie annehmen. Der charakteristische Durchmesser der Haltefläche, auf die sich die folgenden Angaben beziehen, ist jeweils der des einbeschreibbaren Kreises von maximalem Durchmesser.

Für den Austritt des Gases in Richtung Scheibe sind entlang des Umfangs eines konzentrisch in die Haltefläche gedachten Kreises, dessen Durchmesser das 0,1- bis 0,6fache des Tellerdurchmessers entspricht, Ausnehmungen eingebracht, die jeweils gleich weit voneinander entfernt sind, wobei ihr gegenseitiger Abstand, bezogen auf den Kreisumfang, $2/3 \cdot r \cdot \pi$ bis 0 und die lichte Weise diesen Ausnehmungen etwa 0,02 bis 2% des Tellerdurchmessers beträgt. Die Ausnehmungen sitzen entlang der Mantelfläche eines Kegels, dessen Basisfläche der des gedachten Kreises entspricht und dessen Öffnungswinkel ca. 20 bis 150° beträgt. Sie münden im Inneren des Abnehmers in eine Bohrung, die mit einer Gasquelle verbunden ist.

Vorzugsweise wird der Abstand der einzelnen Ausnehmungen zu Null gemacht, wodurch eine Ringdüse entsteht.

Eine einfache Fertigung dieser Ausführungsform wird erreicht, indem der Grundkörper, ausgehend von der Oberfläche, trichterförmig aufgebohrt wird, wobei der Kegelöffnungswinkel ca. 20 bis 150°, vorzugsweise 50 bis 110°, beträgt. Die Trichteröffnung ist 0,02 bis 1%, vorzugsweise 0,02 bis 0,4%, des Tellerdurchmessers größer als ein in die Trichteröffnung eingepaßter kegelstumpfförmiger Kern, dessen Basisdurchmesser das 0,1- bis 0,6fache des Tellerdurchmessers beträgt und dessen Öffnungswinkel 0 bis 50°, vorzugsweise 10 bis 30°, größer ist als der der Trichteröffnung.

Die Halterung des Kegelstumpfes in der Trichteröffnung wird vorzugsweise so gestaltet, daß der Kegelstumpf längs der zentralen Achse bewegt werden kann, wodurch die Spaltbreite (lichte Weite der Ausnehmung) variiert werden kann. Besonders einfach kann dies dadurch geschehen, daß der sich axial dem Kegelstumpf anschließende zylindrische Teil mit einem Außengewinde versehen ist. Die Fixierung erfolgt vorzugsweise durch eine Kontermutter auf diesem Gewinde.

Im Zentrum der Basisfläche des Kegelstumpfes ist eine örtliche Erhöhung zur Abstützung der zu gewinnenden Scheibe angebracht. Vorzugsweise wird diese Erhöhung als Kugel ausgebildet, deren Durchmesser 0,5 bis 3% des Tellerdurchmessers beträgt.

Als Material für die Fertigung des Haltewerkzeugs kann im wesentlichen jedes maschinell bearbeitbare Material verwendet werden, insbesondere Metalle. Die zur Abstützung der Scheibe dienende örtliche Erhöhung besitzt eine Werkstoffhärte, die größer ist, als die der zu gewinnenden Scheibe.

Der Gasstrom wird vorzugsweise so geregelt, daß die Gasströmung im Bereich des Austritts des Gases aus dem Haltewerkzeug laminar ist, wenn auch eine turbulente Strömung die Funktion des Werkzeugs nicht grundsätzlich ausschließt. Das radial ausströmende Gas trifft im spitzen Winkel auf die zu gewinnende Scheibe und erzeugt in an sich bekannter Weise zwischen Haltewerkzeug und Scheibe ein rotationssymmetrisches Druckfeld.

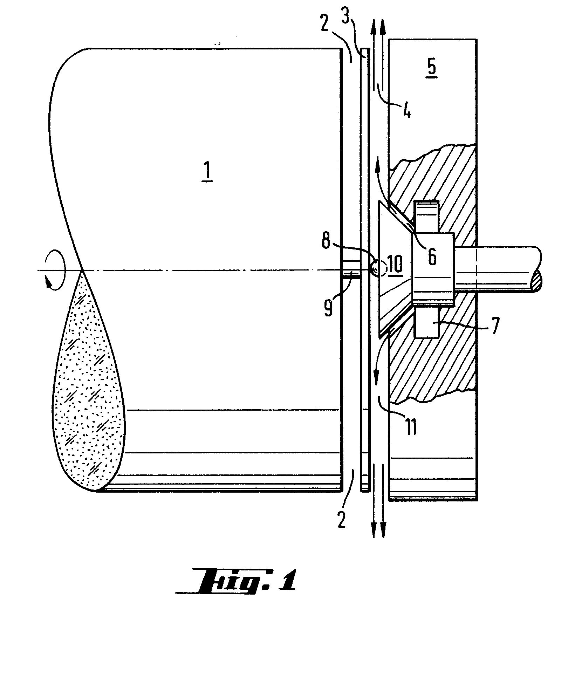

Die Fig. 1, 2 und 3 zeigen bevorzugte Ausführungen des erfindungsgemäßen Haltewerkzeugs. Fig. 1 stellt eine Prinzipskizze dar. Zu dem rotierenden Kristallstab 1 ist das Haltewerkzeug derart justiert, daß die abstützende Kugel 8 das Zentrum der abzutrennenden Scheibe 3 trifft. Die Scheibe ist in der kritischen Phase des Trennvorgangs noch mit einem Stumpf 9 mit dem Kristallstab 1 verbunden, während zum überwiegenden Flächenanteil zwischen Scheibe und Stab bereits der Sägespalt 2 entstanden ist.

Das Haltewerkzeug besteht aus dem Abnehmerteller 5, der eine zur abzutrennenden Scheibe gerichtete konische Bohrung aufweist, die mit dem Leitkegel 10 eine Ringspaltdüse 6 ausbildet. Das Gas durchströmt den Ringkanal 7, gelangt in laminarer Strömung durch die Ringspaltdüse und bestreicht schließlich in rotationssymmetrischer Quellströmung 11 die Scheibe. Im Bereich zwischen Halteteller und Scheibe baut sich ein durch die Strömung des Gases verursachter Unterdruckbereich 4 auf.

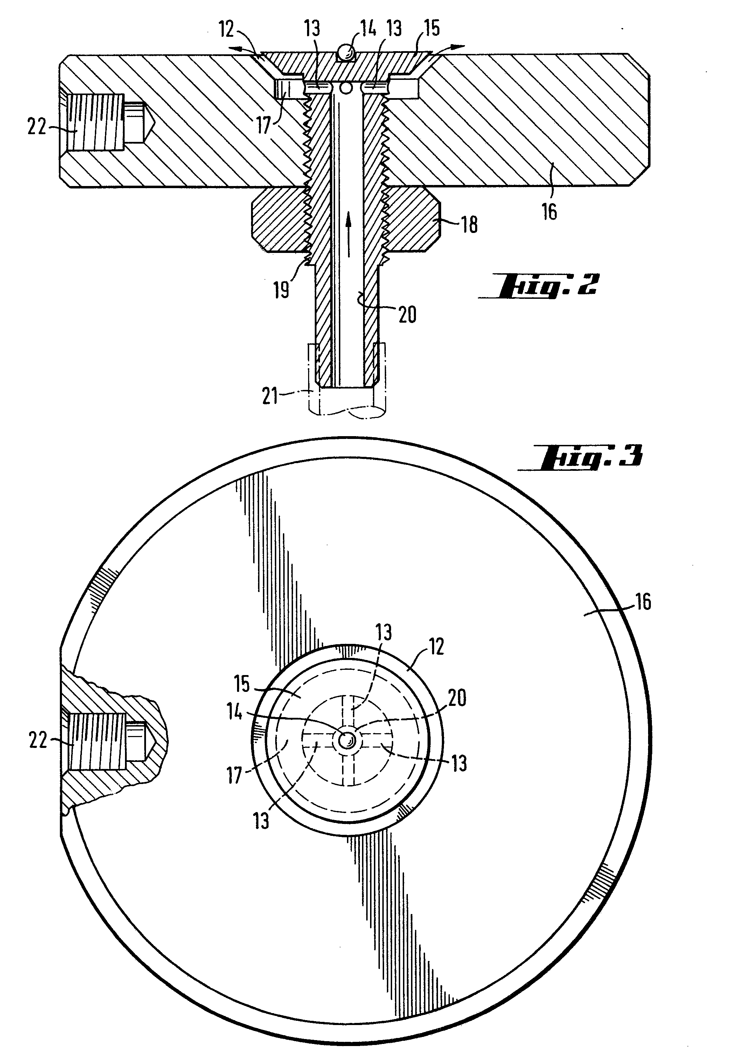

Fig. 2 zeigt den Querschnitt und Fig. 3 die Draufsicht eines erfindungsgemäßen Haltewerkzeugs.

Der Abnehmerteller 16 weist am oberen Ende eine konische Bohrung auf, die mit dem Leitkegel 15 die Ringspaltdüse 12 bildet. Die Verbindung zwischen Abnehmerteller und Leitkegel ist im unteren Teil durch das Gewinde 19 gegeben. Diese Verbindung ist höhenverstellbar und definiert die Breite des Ringspalts 12. Die erwünschte Einstellung kann durch die Kontermutter 18 fixiert werden. Über eine zentrale Bohrung 20 des Leitkegels wird über die Zuleitung 21 Gas eingeblasen, das über Bohrungen 13 eine Ringkammer 17 erreicht und schließlich über den Ringspalt austritt. Die als Abstützung für die abzutrennende (nicht gezeichnete) Scheibe dienende Kugel 14 ist im Zentrum des Abnehmertellers, das zugleich das Zentrum des Leitkegels bildet, angebracht.

Wie aus Fig. 3 zu sehen ist, weist der Abnehmerteller eine seitliche Abflachung mit Bohrung 22 auf, die zur Montage des Haltetellers an eine Abschwenkvorrichtung dient.

Nach dem erfindungsgemäßen Verfahren bzw. mit Hilfe des erfindungsgemäßen Haltewerkzeugs gelingt es, das in der Endphase des Trennvorgangs auftretende Torsionsmoment auf die Restverbindung von zu gewinnender Scheibe und Kristallstab so weit zu verringern, daß der Stumpf rückstandsfrei übersägt werden kann. Die Fixierung der Scheibe erfolgt dabei praktisch ohne Zug- und Biegebeanspruchung, so daß ein planparalleler Schnitt gewährleistet ist.

## Patentansprüche

1. Verfahren zum Aufnehmen von Kristallscheiben, die durch einen Trennvorgang gewonnen werden, mittels eines Haltewerkzeugs unter Ausnutzung der Sogwirkung an der Scheibe (3) vorbeiströmenden Gases, dadurch gekennzeichnet, daß die Scheibe (3) im Zentrum annähernd punktförmig abgestützt wird.

2. Verfahren nach Anspruch 1, dadurch gekennzeichnet, daß der Trennvorgang mittels Innenlochsäge vorgenommen wird, vorzugsweise unter Eigenrotation eines Kristallstabes (1), aus dem die Scheiben (3) gewonnen werden.

3. Haltewerkzeug zur Durchführung des Verfahrens nach den Ansprüchen 1 und 2, dadurch gekennzeichnet, daß die Haltefläche des Haltewerkzeugs im Zentrum eine punktförmig auslaufende Erhöhung (8; 14) aufweist.

## Claims

1. Process for picking up crystalline wafers by means of a holding tool utilizing the suction effect of gas flowing past the wafer obtained by means of a separation operation, characterized in that the wafer (3) is supported at the centre by an almost point-like support.

2. Process according to claim 1, characterized in that the separation operation is carried out by means of a circular saw having an internal cutting edge, preferably with rotation of the crystalline rod (1) itself from which the wafers (3) are to be obtained.

3. Holding tool for carrying out the process according to claims 1 and 2, characterized in that the holding face of the holding tool has, at the centre, a pointlike projection (8; 14).

## Revendications

1. Procédé pour lever des plaquettes cristallines qui sont produites par une opération de séparation, au moyen d'un outil de retenue, en tirant parti de l'effet d'aspiration d'un gaz qui lèche la plaquette (3), caractérisé en ce que la plaquette (3) est soutenue en son centre, en une zone approximativement ponctuelle.

2. Procédé selon la revendication 1, caractérisé en ce que l'opération de séparation est réalisée au moyen d'une scie à trou intérieur, de préférence avec rotation propre d'une barre cristalline (1) à partir de laquelle les plaquettes (3) sont produites.

3. Outil de retenue pour la mise en œuvre du procédé selon les revendications 1 et 2, caractérisé en ce que la surface de retenue de l'outil de retenue présente en son centre une protubérance (8; 14) se terminant avec une forme ponctuelle.

**Fig. 1**

Fig. 2

Fig. 3